Europäisches Patentamt

European Patent Office

Office européen des brevets

(19)

(11) Publication number: **0 018 802**
**B1**

(12) **EUROPEAN PATENT SPECIFICATION**

(45) Date of publication of patent specification: 23.05.84

(51) Int. Cl.³: **H 01 L 41/22, H 01 G 7/02**

(21) Application number: 80301372.1

(22) Date of filing: 25.04.80

(54) **Process for preparing a piezoelectric pyroelectric film, and capacitors, piezoelectric and pyroelectric devices incorporating the film.**

(30) Priority: 26.04.79 JP 51940/79

(43) Date of publication of application:
12.11.80 Bulletin 80/23

(45) Publication of the grant of the patent:
23.05.84 Bulletin 84/21

(84) Designated Contracting States:
DE FR GB NL

(56) References cited:
FR-A-2 265 805
FR-A-2 275 033
GB-A-2 020 483

JOURNAL OF APPLIED PHYSICS, vol. 41, no. 6,
May 1970, pages 2365-2375 New York, U.S.A.
R.A. CRESWELL: "Thermal Currents from
Corona Charged Mylar"

(73) Proprietor: RIKAGAKU KENKYUSHO
2-1 Hirosawa
Wako-shi Saitama-ken (JP)
(73) Proprietor: KUREHA KAGAKU KOGYO
KABUSHIKI KAISHA
9-11 Horidome-cho 1-chome Nihonbashi Chuo-
ku
Tokyo (JP)

(72) Inventor: Fukada, Eiichi
1-105 Sanraito Mansion 2-5-2 Mizuhodai
Fujimi-shi Saitama-ken (JP)
Inventor: Furukawa, Takeo
1-17-8 Niiza-shi Saitama-ken
JP (JP)
Inventor: Date, Munehiro
2-12-24 Shirogganedai Minato-ku
Tokyo (JP)
Inventor: Nakamura, Ken'ichi
154-3 Harada Nishiki-machi
Iwaki-shi Fukushima-ken (JP)
Inventor: Nakamura, Ken'ichi
154-3 Harada Nishiki-machi
Iwaki-shi Fukushima-ken (JP)

(74) Representative: Myerscough, Philip Boyd et al
J.A.Kemp & Co. 14, South Square Gray's Inn
London, WC1R 5EU (GB)

## Description

This invention relates to piezolelectric and pyroelectric films prepared by stretching and polarizing a polymeric film.

Polymeric materials such as polyvinylidene fluoride or polyvinyl fluoride are piezoelectric and pyroelectric when they are made into electrets, for example, by the application of a d.c. electric field under heating. In the process of preparing a piezoelectric and pyroelectric film from a polymeric film, the steps of stretching the film and applying a voltage across the film are necessary. These steps may be conducted either separately or simultaneously.

The former technique of separately stretching a polymeric film before the application of a voltage across it has been employed widely. High polymeric films having high piezoelectricity and pyroelectricity, can be obtained. However, the piezoelectric and pyroelectric effects thus obtained are unstable and reduce with time. On the other hand, piezoelectric and pyroelectric polymeric films obtained by the latter method of simultaneously stretching and applying a voltage do not provide high piezoelectricity and pyroelectricity, although they are stable.

An example of the latter method is published in Japanese Patent Publication No. 45798/76 in which a high polymeric film is polarized while stretched in a pair of rolls across which a voltage is applied. It is difficult to obtain a high piezoelectric constant and pyroelectric coefficient in this process since only a restricted portion of the film is polarized, that is at the contact point with the rolls, and the polarizing time is not sufficient.

A method of stretching a film while positioning plate electrodes close to both sides of it and applying a voltage between the electrodes is also known. Insufficient piezoelectric and pyroelectric properties are derived this way, however, since if the electrodes are kept in close contact with the film before stretching they can not be kept in this state during stretching.

Polyvinylidene fluoride (PVDF) takes various crystalline forms including $\alpha$-type, $\beta$-type and $\gamma$-type. PVDF films in the form of the $\beta$-type or the $\gamma$-type are useful as dielectric materials. Their molecule chains have a planar zig-zag conformation and unit cell dipole moments exist. The $\beta$-type and the $\gamma$-type crystalline forms are hereinafter referred to collectively as the I type although this is somewhat different from the usual meaning attributed to this term.

I Type crystals can be obtained, for example, by stretching a heat molded sheet. The morphology depends on the method of stretching. According to the definition for crystallographic axes in Hasegawa et al, Polymer Journal, Vol. 3, No. 5, p. 600—610 (1972), the direction of the molecule chain is taken as axis c, the direction perpendicular to axis c and parallel with the dipoles is taken as axis b and the direction perpendicular both to axis c and axis b is taken as axis a. According to this definition, in a mono-axially stretched film axis c tends to be arranged in the direction of stretching when viewing the film surface, whilst axes a and b tend to be arranged at random looking at a cross section of the film perpendicular to the stretching direction. On the other hand, in a bi-axially oriented film axis c tends to be arranged at random when viewing the film surface, but axis b is aligned parallel to the film surface and axis a is aligned in a direction perpendicular to the film surface when viewing a cross section of the film.

Since mono-axially and bi-axially stretched PVDF films have a dielectric constant of 10 to 13, which is 3 to 4 times as great as that of polyester films, they are utilized as capacitors in portable medical defibrillators. Their use as capacitors for nuclear fusion devices is under consideration. So-called double oriented PVDF films composed of I type crystals in which both axes c and b are oriented and, accordingly, axis a is also oriented have, however, become known only recently. In one such film, reported in DE—OS 29 30 370, the dipoles are oriented parallel with the film surface. In the Journal of Applied Physics, Vol. 50, p. 6091—6094, a film is disclosed in which the dipoles are oriented perpendicular to the film surfaces. The latter film is obtained by stretching and then rolling a film. However, in order to obtain a desired film thickness the film has to be rolled several times. Further, the thickness of the film obtained even after repeated rolling is at least about 60 $\mu$. In the case of a piezoelectric film in which dipoles are oriented perpendicular to the film surface, films should be as thin as possible since a thicker film is less likely to vibrate as compared with a thinner film of the same substance. In the case of a pyroelectric film, it is also desired to decrease the film thickness since heat capacitance is greater and sensitive conversion of temperature changes into electric changes is difficult as the film thickness increases.

In an effort to ovecome the problems associated with prior art methods of preparing piezoelectric and pyroelectric films, the present invention provides a process for preparing a piezoelectric pyroelectric film of a high polymer which process comprises stretching a polyvinylidene fluoride type film disposed between electrodes whilst causing a corona discharge between said electrodes thereby to polarize said film, at least one electrode on at least one side of said film having a pointed tip pointing towards but being spaced from said film and said stretching and polarisation being effected at a temperature of 110°C or below, so as to produce said piezoelectric and pyroelectric film.

The tip of at least one of the electrodes between which the polymeric film is positioned when it is stretched is pointed. Such electrodes may be needle-like or saw tooth-like in shape. An electrode of such configuration is provided on at least one side of the film to be stretched. The pointed electrodes are disposed so that the corona discharge occurs at least where the film is stretched. A plurality of electrodes may be provided on one side or on both sides of the film. If corona discharging is conducted under heating, it is preferable to continue the discharge until the film has cooled to some extent after the stretching. The discharge can begin before stretching. The polymeric film is stretched transversely to the electric field due to the corona discharge.

In the process of this invention, satisfactory results are obtained by setting the temperature during polarization and stretching preferably to below 80°C, more preferably between room temperature (15°C) and 70°C and still more preferably between 30 and 60°C. Better results can be obtained if the temperature is towards the top end of these ranges if the stretching ratio and the stretching speed are great or is towards the lower end of these ranges if the stretching ratio and stretching speed are small.

The polymeric films usable in this invention are polyvinylidene fluoride type films or sheets, for example of vinylidene fluoride homopolymer, a copolymer of vinylidene fluoride and at least one comonomer copolymerisable therewith, for example a halogenoalkene such as vinyl fluoride, tetrafluoroethylene or chlorotrifluoroethylene, the copolymer containing more than 50 mol% of vinylidene fluoride units in the main polymer chain, or a composition consisting predominantly of such a homopolymer and/or copolymer and also containing a compatible resin, for example poly(methyl methacrylate) or poly(methyl acrylate). Other materials may be included in the composition.

Stretched or non-stretched polyvinylidene fluoride type films or sheets may be used. For example, double-oriented piezoelectric pyroelectric films in which dipoles are oriented substantially in the direction of the thickness can be provided by stretching a previously stretched film in a direction substantially perpendicular to the previous stretching direction, while corona discharging.

The PVDF films obtained by the process of the invention can easily attain a thickness below 50 $\mu$ and mainly consist of I-type crystals in which dipoles are oriented substantially in the direction of the thickness to form double orientation.

The invention is further described, by way of example, referring to the accompanying drawings in which:

Figure 1 is a schematic view showing the structure of a polyvinylidene fluoride film obtained by a process according to this invention;

Figure 2 is an infrared absorption spectrum of polyvinylidene fluoride;

Figure 3 is a wide angle X-ray diffraction photograph for a piezoelectric and pyroelectric film prepared according to this invention;

Figure 4 is a wide angle X-ray diffraction photograph where axes a and b are oriented randomly;

Figure 5 is a schematic view of one type of device which may be employed to carry out the process of this invention;

Figure 6 is a schematic view of a further type of device which may be employed to carry out the process of this invention; and

Figure 7 is a schematic view of a still further type of device which may be employed to carry out the process of this invention.

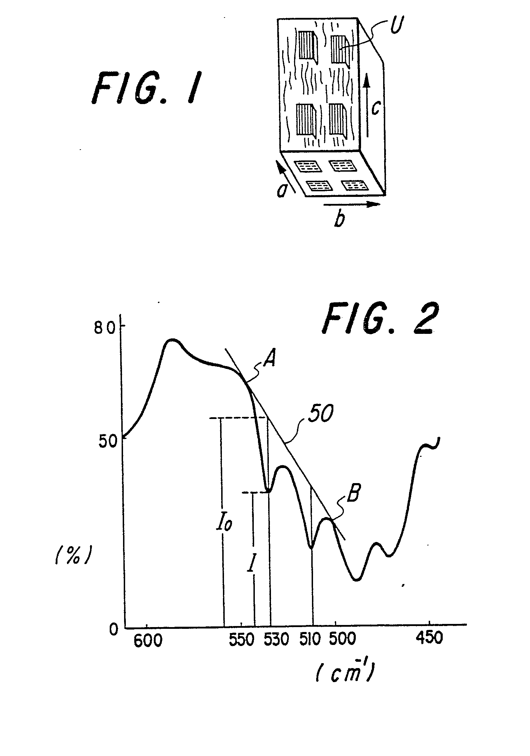

As shown in Figure 1, PVDF film which is prepared by this invention is a film of double-orientation which consists essentially of I-type crystals. In Figure 1, a, b, c correspond to the directions of the axes a, b, and c, axis b being vertical to the film surface, and U denotes each crystallite.

The proportion of I-type crystal in a given crystal can be determined by infrared absorption spectroscopy. The degree of the double orientation can be judged by using wide angle X-ray diffraction photography. These techniques are discussed below:

An example of the infrared absorption spectrum of a crystal is shown in Figure 2. In this Figure, the vertical axis represents transparent ratio (%) and the horizontal axis represents wave number (cm$^{-1}$). The proportion of I-type crystal can be found by measuring the absorbance ratio at 510 cm$^{-1}$ and 530 cm$^{-1}$, represented as $D_{510}$, $D_{530}$ respectively. Absorbance at 510 cm$^{-1}$ corresponds to the absorption by I-type crystals and the absorbance at 530 cm$^{-1}$ corresponds to the absorption by II-type crystals.

Point A is plotted at a peak value around 530 cm$^{-1}$, and point B is plotted at a peak value around 510 cm$^{-1}$. A base line 50 is drawn from A to B. Absorbances $D_{510}$ and $D_{530}$ are the differences between base line ($I_0$) and transparent rate (I) at 510 cm$^{-1}$ and 530 cm$^{-1}$ respectively. Using these absorbances, the ratio of I-type crystal in a crystal can be calculated by the formula:

Ratio of I-type crystal in crystal (%)

$$= \frac{D_{510}}{D_{510} + D_{530}} \times 100$$

This ratio is desirably more than 50%, more preferably more than 65%, more preferably still more than 75%.

The orientation of the crystals is judged by wide angle X-ray diffraction photography. A wide angle X-ray diffraction photograph is taken by setting the film cross section, which is cut perpendicular to the stretching direction, while placing its width direction vertically. The film is subjected to X-rays (CuK$\alpha$ rays) in a direction perpendicular to its cross section. The crystal orientation mode is judged by whether the diffraction images on the face (200) and face (110) of the I-type crystals form 6-dot images or 6-arcuate images or not.

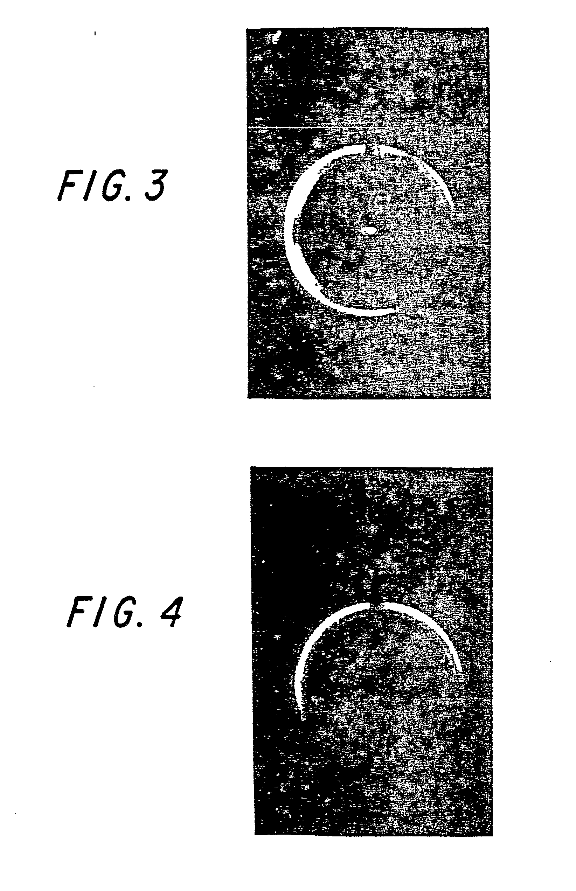

As the degree of the double orientation becomes more significant, the 6-dot images are observed more clearly as 6 points. As the degree of the double orientation diminishes the 6-dot images become blurred into 6-arcuate images as shown in Figure 3. Further, if the axes a and b are oriented at random in the film cross section, ring-like images on the same circle are observed as shown in Figure 4.

Films exhibiting 6-arcuate images, although somewhat indistinct as shown in Figure 3, are within the scope of films prepared in accordance with this invention. That is to say, if the axis b is oriented nearly vertically to the film surface, it is regarded as being substantially oriented vertically. The configuration in Figure 3 may be seen as a ring if not observed carefully. However, the intensities of the diffraction images situated at the top and bottom of the photograph, which can be recognised as arcuate images on the face (200), and of the images situated along four oblique directions, which can be recognised as the arcuate images on the face (110), appear greater than those in their vicinity. On the other hand, in Figure 4 the diffraction intensities of the images at these locations are not greater than those at other locations. Consequently, the two cases can be distinguished from each other.

Whether or not the dipoles are oriented substantially in the direction of the film thickness is judged by whether the images on the face (200) are formed as dot images or arcuate images at the top and bottom as shown in Figure 3. If the images of the face (200) are formed at the right and the left of the photograph, it shows that the dipoles are oriented in parallel with the film surfaces.

The following Examples illustrate the invention:

## Example 1

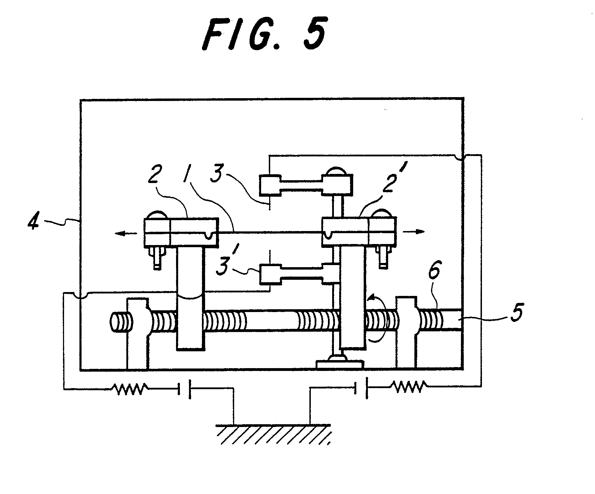

The apparatus shown in Figure 5 comprises stretching means 2, 2' for pinching film 1 therebetween and stretching it in the direction of the arrow, and needle-like electrodes 3, 3' spaced $10^{-2}$ m (1 cm) from the surfaces of the film 1 in a thermostat 4. The stretching means 2, 2' are threaded for engagement with the threads 6 formed on shaft 5 and are adapted to move horizontally on rotation of the shaft.

Although single needle-like electrodes 3, 3' are illustrated in Figure 5, needles are actually arranged side by side for each surface of the film 1 having $2 \times 10^{-2}$ m (2 cm) width. A positive voltage is applied to the needle electrodes 3 and a negative voltage is applied to the needle electrodes 3'.

The method of producing piezoelectric and pyroelectric polyvinylidene fluoride films using this apparatus is described as follows:

A film 1 of $10^{-4}$ m (100 $\mu$) thickness made of vinylidene fluoride homopolymer or a film of $1.4 \times 10^{-4}$ m (140 $\mu$) thickness made of a copolymer consisting of 95% by weight of vinylidene fluoride and 5% by weight of vinyl fluoride was fixed to the stretching means 2, 2'. The stretching means were operated by rotation of the shaft 5 to stretch each film by a stretching factor of 4 at a predetermined temperature for 10 min while applying +6KV to the upper electrode 3 and −6KV to the lower electrode 3' to thereby produce corona discharging. Since films could not be stretched by a factor of 4 at 25°C and 30°C, they were stretched by a factor of 3 and 3.7 respectively at these temperatures.

When the film had cooled to room temperature after the stretching, the corona discharging was stopped. The piezoelectric constant $d_{31}$ for 10 Hz vibration at room temperature and the pyroelectric coefficient dPs/dT at 23°C were measured for the piezoelectric and pyroelectric films thus formed onto which silver electrodes had been vapor-deposited. The results are shown in Table 1 (polyvinylidene fluoride homopolymer) and Table 2 (copolymer).

As a comparison, simultaneous stretching and polarisation was effected at 80°C, 100°C and 120°C. As a further comparison the homopolymer and copolymer films were first stretched at 80°C by a factor of 4 then subjected to a corona discharge for 10 minutes by applying +6KV to the upper electrode 3 and −6KV to the lower electrode 3' at temperatures of 25°C, 30°C, 40°C, 50°C, 60°C, 70°C, 80°C, 100°C and 120°C using the apparatus as shown in Figure 5. Thereafter, the films were cooled to room temperature. The results are also shown in Table 1 (polyvinylidene fluoride homopolymer) and Table 2 (copolymer).

TABLE 1

| Polarizing temperature (°C) | Example (simultaneous stretching and polarization) | | | Comparison Example (stretching at 80°C) | | |
|---|---|---|---|---|---|---|
| | $d_{31}$ $(10^{-12}$ C /N) | | dPs /dT $(10^{-9}$ C /cm$^2$·deg) | $d_{31}$ $(10^{-12}$ C /N) | | dPs /dT $(10^{-9}$ C /cm$^2$·deg) |
| | immediately after | 10 days after | | immediately after | 10 days after | |
| 25 | 30 (stretching × 3) | 27 | 5.4 | 18 | 11 | 2.2 |
| 30 | 35 (stretching × 3.7) | 31 | 6.2 | 18 | 12 | 2.2 |
| 40 | 38 | 35 | 7.3 | 18 | 12 | 2.3 |
| 50 | 40 | 38 | 8.0 | 22 | 14 | 2.6 |
| 60 | 38 | 34 | 7.2 | 25 | 17 | 2.8 |
| 70 | 36 | 31 | 6.3 | 29 | 18 | 3.5 |
| 80 (Comparison) | 35 | 25 | 5.3 | 32 | 20 | 4.1 |
| 100 (Comparison) | 22 | 10 | 2.1 | 24 | 17 | 2.8 |
| 120 (Comparison) | 8 | 5 | 1.1 | 8 | 5 | 0.6 |

TABLE 2

| EXAMPLE | | |
| --- | --- | --- |
| Polarizing temperature (°C) | $d_{31}$ ($10^{-12}$ C/N) | |
| | immediately after | 3 days after |
| 40 | 30 | 24 |
| 60 | 30 | 24 |

As can be seen from the Tables 1 and 2, the polyvinylidene fluoride homopolymer films obtained by the process of this invention have greater piezoelectric constants and pyroelectric coefficients and are more stable over a period of time as compared with those obtained by conducting polarization after separately stretching the films. The same results also occurred for the vinylidene fluoride copolymer films.

It will be apparent that while six needles are arranged in one row on one side in the foregoing embodiment, the needle electrodes may be arranged in several rows. In addition, while the film was stretched in two-directions, i.e. to the right and to the left in Figure 5, it is possible to stretch the film in other ways, for example by pulling it in one direction such as between two take-up rolls while a corona discharge is generated. Such an embodiment is shown below.

Example 2

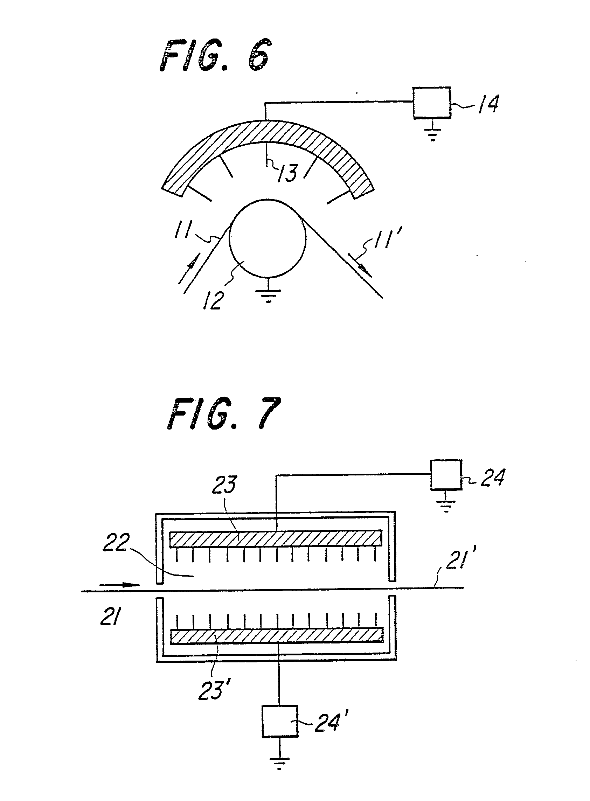

Figure 6 shows another embodiment for practicing this invention. A film 11 of $6 \times 10^{-5}$ m (60 $\mu$) thickness made of vinylidene fluoride homopolymer runs from the left hand side of Figure 6 by way of a send roll (not shown) to a heating roll 12 at $1.66 \times 10^{-3}$ m/s (10 cm/min), then pulled from the heating roll 12 to the right by a take-up roll (not shown) at $6.66 \times 10^{-3}$ m/s (40 cm/min) and made into a film 11' of $2.5 \times 10^{-5}$ m (25 $\mu$) thickness on the right side of the heating roll 12. The heating roll 12 has a diameter of $2 \times 10^{-1}$ m (20 cm). It is earthed. Five needle electrodes 13 with appropriate needle pitch are disposed pointing toward the centre of the heating roll 12. These electrodes are spaced $8 \times 10^{-3}$ m (8 mm) from the surface of the heating roll 12. An 8 kV voltage is applied between the needle electrodes and the roll surface by means of a high voltage DC power supply 14. The films prepared by this method had aluminum electrodes vapor deposited on to both surfaces thereof and their piezoelectric constants $d_{31}$

were measured as in Example 1. The piezoelectric constant $d_{31}$ was $32 \times 10^{-12}$ C/N immediately after preparation and $28 \times 10^{-12}$ C/N one month afterwards.

Example 3

Figure 7 shows further apparatus for practicing this invention. A film 21 of $10^{-4}$ m (100 $\mu$) thickness made of vinylidene fluoride homopolymer runs from the left in Figure 7 by a send roll (not shown) to a temperature control bath 22 at $1.66 \times 10^{-3}$ m/s (10 cm/min) and then is stretched to the right of the control bath 22 at $6.66 \times 10^{-3}$ m/s (40 cm/min) by another roll (not shown) and made into a film 21' $3.3 \times 10^{-5}$ m (33 $\mu$) thick. The temperature control bath 22 is maintained to 45°C and necking stretching was conducted in this bath. Needle electrode groups 23, 23' are provided 1 cm above and below the films 21 and 21'. A voltage of +6KV is applied to the needle electrodes 23 and of −6KV is applied to the needle electrodes 23' from high voltage DC power supplies 24, 24' during stretching. The films prepared in this way were vapor-deposited with aluminum electrodes on both surfaces thereof. Their piezoelectric constants $d_{31}$ were measured as in Example 1. The constant was $35 \times 10^{-12}$ C/N immediately after preparation and $31 \times 10^{-12}$ C/N one month afterwards. The proportion of I-type crystal in the crystal system of the stretched films was 70% as measured by infrared absorption. The crystal orientation mode was as shown in Figure 3. For comparison, films were treated in the same manner except that polarization was conducted after stretching. The piezoelectric constant $d_{31}$ of such comparative films was $27 \times 10^{-12}$ C/N just after their preparation and $19 \times 10^{-12}$ C/N after one month. The proportion of I-type crystal in the crystal system of the stretched films was 75% and the crystal orientation mode was as shown in Figure 4.

Since the films prepared according to this invention are polarized under the application of an electric field, they can be used as they are as piezoelectric films or pyroelectric films. They may have high piezoelectric constants and pyroelectric coefficients as well as being stable and can be prepared as thin films. Accordingly, they can be used wherever conventional piezoelectric films or pyroelectric films find applications, for example as the dielectric material such as in capacitors. Furthermore, since their dipoles are oriented in specific directions, the films prepared according to this invention may possess excellent photoelectric properties, and, are industrially useful in a broad range of electrical materials.

By adopting the process of the present invention it is possible to obtain piezoelectric and pyroelectric films having a thickness below 50 $\mu$, preferably below 40 $\mu$ more preferably below 30 $\mu$, and having a double-oriented structure in which dipoles are oriented substantially in the direction of the thickness of the film.

### Claims

1. A process for preparing a piezoelectric and pyroelectric film of high polymer, characterised in that a polyvinylidene fluoride type film (1; 11; 21) disposed between electrodes (3,3'; 12, 13; 23,23') is stretched whilst causing a corona discharge between said electrodes thereby to polarize said film, at least one electrode on at least one side of said film having a pointed tip pointing towards but being spaced from said film and said stretching and polarization being effected at a temperature of 110°C or below, so as to produce said piezoelectric and pyroelectric film.

2. A process according to claim 1, wherein all electrodes (3,3'; 23,23') between which the film (1;21) is disposed have pointed tips.

3. A process according to claim 1 or 2 wherein the or each electrode having a pointed tip has a needle-like or saw-tooth shape.

4. A process according to any one of the preceding claims, wherein a positive voltage is applied to the or each electrode (3; 23) on one side of the film (1; 21) and a negative voltage is applied to the or each electrode (3'; 23') on the other side of said film.

5. A process according to any one of the preceding claims wherein stretching and polarisation is effected at a temperature below 80°C.

6. A process according to claim 5 wherein stretching and polarization is effected below 70°C but above room temperature.

7. A process according to claim 6 wherein stretching and polarization is effected between 30°C and 60°C.

8. A process according to any one of the preceding claims wherein said film (1; 11; 21) is a vinylidene fluoride homopolymer.

9. A process according to any one of the preceding claims wherein said piezoelectric and pyroelectric polyvinylidene fluoride type film is obtained by stretching a previously stretched film in a direction substantially perpendicular to the previous stretching direction whilst polarising said previously stretched film.

10. A capacitor incorporating a film prepared by a process as claimed in any one of the preceding claims as a dielectric material.

11. A piezoelectric device or a pyroelectric device incorporating a film prepared by a process as claimed in any one of claims 1 to 9.

### Revendications

1. Procédé pour préparer un film piézoélectrique et pyroélectrique en un haut polymère, caractérisé par le fait qu'un film de type fluorure de polyvinylidène (1, 11, 21) disposé entre des électrodes (3, 3', 12, 13, 23, 23') est étiré pendant que l'on provoque une décharge corona entre lesdites électrodes pour ainsi polariser ledit film, au moins une électrode sur au moins un des côtés du film possédant une extrémité pointue dirigée vers ledit film mais espacée de celui-ci, et lesdits étirage et polarisation étant effectués à une température de 110°C ou inférieure de façon à produire ledit film piézoélectrique et pyroélectrique.

2. Procédé selon la revendication 1, caractérisé par le fait que toutes les électrodes (3, 3', 23, 23') entre lesquelles est disposé le film (1, 21) possèdent des extrémités pointues.

3. Procédé selon la revendication 1 ou 2, caractérisé par le fait que la ou chaque électrode possédant une extrémité pointue présente une forme analogue à une aiguille ou une dent de scie.

4. Procédé selon l'une quelconque des revendications précédentes, caractérisé par le fait qu'une tension positive est appliquée à la ou chaque électrode (3, 23) sur un côté du film (1, 21) et une tension négative est appliquée sur la ou chaque électrode (3', 23') de l'autre côté du film.

5. Procédé selon l'une quelconque des revendication précédentes, caractérisé par le fait que l'étirage et la polarisation sont effectués à une température inférieure à 80°C.

6. Procédé selon la revendication 5, caractérisé par le fait que l'étirage et la polarisation sont effectués à moins de 70°C mais au-dessus de la température ambiante.

7. Procédé selon la revendication 6, caractérisé par le fait que l'étirage et la polarisation sont effectués entre 30°C et 60°C.

8. Procédé selon l'une quelconque des revendications précédentes, caractérisé par le fait que ledit film (1, 11, 21) est un homopolymère de fluorure de vinylidène.

9. Procédé selon l'une quelconque des revendications précédentes, caractérisé par le fait que le film piézoélectrique et pyroélectrique de type fluorure de polyvinylidène est obtenu en étirant un film précédemment étiré dans un sens sensiblement perpendiculaire au sens de l'étirage précédent tout en polarisant ledit film précédemment étiré.

10. Condensateur comportant un film préparé par un procédé selon l'une quelconque des revendications précédentes en tant que matériau diélectrique.

11. Dispositf piézoélectrique ou dispositif pyroélectrique comprenant un film préparé par un procédé selon l'une quelconque des revendications 1 à 9.

## Patentansprüche

1. Verfahren zur Herstellung eines piezoelektrischen und pyroelektrischen Filmes aus einem Hochpolymeren, dadurch gekennzeichnet, daß ein Film aus einem Polyvinylidenfluorid (1; 11; 21), der zwischen Elektroden (3, 3'; 12, 13; 23, 23') angeordnet ist, gereckt wird, während eine Corona-Entladung zwischen den Elektroden erfolgt, um dadurch den Film zu polarisieren, daß wenigstens eine Elektrode an wenigstens einer Seite des Filmes eine Spitze aufweist, welche zu dem Film gerichtet ist, aber von dem Film einen Abstand aufweist, und daß die Reckung und Polarisierung bei einer Temperatur von 110°C oder darunter erfolgt, um den piezoelektrischen und pyroelektrischen Film herzustellen.

2. Verfahren nach Anspruch 1, dadurch gekennzeichnet, daß alle Elektroden (3, 3'; 23, 23'), zwischen welchen der Film (1; 21) angeordnet ist, Spitzen aufweisen.

3. Verfahren nach Anspruch 1 oder 2, dadurch gekennzeichnet, daß die oder jede Elektrode eine nadelartige oder sägezahnförmige Spitze aufweist.

4. Verfahren nach einem der vorhergehenden Ansprüche, dadurch gekennzeichnet, daß eine positive Spannung an die Elektrode oder jede der Elektroden (3; 23) an einer Seite des Films (1; 21) und eine negative Spannung an die Elektrode oder jede der Elektroden (3'; 23') an der anderen Seite des Films angelegt wird.

5. Verfahren nach einem der vorhergehenden Ansprüche, dadurch gekennzeichnet, daß die Reckung und Polarisierung bei einer Temperatur unterhalb 80°C vorgenommen wird.

6. Verfahren nach Anspruch 5, dadurch gekennzeichnet, daß die Reckung und Polarisierung bei einer Temperatur von weniger als 70°C aber von mehr als Raumtemperatur erfolgt.

7. Verfahren nach Anspruch 6, dadurch gekennzeichnet, daß die Reckung und Polarisierung zwischen 30° und 60°C durchgeführt wird.

8. Verfahren nach einem der vorhergehenden Ansprüche, dadurch gekennzeichnet, daß der Film (1; 11; 21) aus einem Vinylidenfluorid-Homopolymerisat ist.

9. Verfahren nach einem der vorhergehenden Ansprüche, dadurch gekennzeichnet, daß der piezoelektrische und pyroelektrische Film aus einem Polyvinylidenfluorid erhalten wird durch Reckung eines vorhergehend gereckten Filmes in einer Richtung im wesentlichen senkrecht zu der Richtung der vorhergehenden Reckung, während der vorhergehend gereckte Film polarisiert wird.

10. Kondensator unter Verwendung eines Filmes, der mit dem Verfahren nach einem der vorhergehenden Ansprüche als dielektrisches Material hergestellt wurde.

11. Piezoelektrische Vorrichtung oder pyroelektrische Vorrichtung unter Verwendung eines Filmes, der durch ein Verfahren nach einem der Ansprüche 1 bis 9 hergestellt wurde.

FIG. 1

FIG. 2

FIG. 3

FIG. 4

# FIG. 5

## FIG. 6

## FIG. 7